(19) Europäisches Patentamt
European Patent Office
Office européen des brevets

(11) **EP 1 972 015 B1**

(12) **EUROPÄISCHE PATENTSCHRIFT**

(45) Veröffentlichungstag und Bekanntmachung des Hinweises auf die Patenterteilung:
**24.10.2012 Patentblatt 2012/43**

(21) Anmeldenummer: **06830642.2**

(22) Anmeldetag: **15.12.2006**

(51) Int Cl.:
*H01L 41/047* (2006.01)    *H04R 17/00* (2006.01)

(86) Internationale Anmeldenummer:
**PCT/EP2006/069747**

(87) Internationale Veröffentlichungsnummer:
**WO 2007/077107 (12.07.2007 Gazette 2007/28)**

(54) **MONOLITHISCHES BIEGEELEMENT**

MONOLITHIC BENDING ELEMENT

ELEMENT FLECHISSANT MONOLITHIQUE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **02.01.2006 DE 102006000698**
**25.08.2006 DE 102006039858**

(43) Veröffentlichungstag der Anmeldung:
**24.09.2008 Patentblatt 2008/39**

(73) Patentinhaber: **CeramTec GmbH**
**73207 Plochingen (DE)**

(72) Erfinder:
• **BINDIG, Reiner**
**95463 Bindlach (DE)**

• **HANDSCHUH, Kurt**
**90542 Eckental (DE)**
• **VOIGT, Claudia**
**90552 Röthenbach (DE)**
• **SCHMIDT, Jürgen**
**95615 Marktredwitz (DE)**
• **SCHREINER, Dr. Hans-Jürgen**
**91233 Neunkirchen am Sand-Rollhofen (DE)**

(74) Vertreter: **Uppena, Franz et al**
**Patente, Marken & Lizenzen**
**c/o Chemetall GmbH**
**Trakehner Straße 3**
**60487 Frankfurt am Main (DE)**

(56) Entgegenhaltungen:
US-A1- 2002 046 861    US-A1- 2005 115 039
US-A1- 2005 115 039    US-A1- 2005 120 528

**Beschreibung**

Die Erfindung betrifft ein Verfahren zur Herstellung eines Bauteils als monolithisches Vielschichtelement oder Vielschicht-Biegeelement nach dem Oberbegriff des Anspruchs 1 und die Verwendung dieses Bauteils.

Zur Anregung von Schwingungen in elastischen Materialien, wie Kunststoffstrukturen oder Membranen, werden normalerweise elektrodynamische Systeme eingesetzt. Ziel dabei ist es, die Struktur-Schallwellen in einem möglichst breiten Frequenzband bei gleichmäßig hohem Schalldruck abstrahlen zu lassen oder eine bereits schwingende Struktur so zu bedämpfen, dass die Schallabstrahlung unterbleibt.

Der Nachteil elektrodynamischer Schwingungserreger ist, dass sie voluminös und bei höheren Leistungen auch schwer sind. Sie sind unter Einhaltung eines hohen Schalldrucks nur bedingt miniaturisierbar. Der Einsatz in Kleingeräten wird so erschwert.

Als Alternative kommen Mehrlagen-Biegeelemente auf piezokeramischer Basis zum Einsatz. Diese Biegeelemente lassen sich flächig an der schwingenden Struktur anbringen und benötigen nur sehr wenig Einbauraum. Sie können bei geeigneter Anbringung in Kleingeräten hohe Schalldruckpegel bei sehr guter Klangqualität erzeugen. Der Einsatz in Großgeräten führt zu flächigen und leichten Systemen.

Die Herstelltechnologie dieser Bauteile ist jedoch sehr aufwändig und für die Innenelektroden muss Edelmetall verwendet werden. Aus diesen Gründen ist der Einsatz von Mehrlagen-Biegeelementen im Massenmarkt nicht möglich. Sollen größere Strukturen, wie Flachlautsprecher, mit derartigen Biegeelementen ausgestattet werden, so benötigt man sehr viele davon. Auch hier verbietet sich der Einsatz aus Kostengründen.

Zudem haben derartige Biegeelemente in Verbindung mit der schwingenden Struktur eine Folge von Resonanzstellen bei definierten Frequenzen, und damit eine charakteristische Klangfärbung des abgestrahlten Schalls. Es hat sich gezeigt, dass für eine breitbandige, neutrale Schallabstrahlung die Geometrie des Biegeelementes für jede schwingende Struktur optimiert werden muss. Für größere Strukturen mit vielen Biegeelementen wiederum müssen für diesen Zweck Biegeelemente verschiedener Geometrie gleichzeitig zum Einsatz kommen. Mit dem erfindungsgemäßen Verfahren (siehe weiter unten) lassen sich verschiedenste Biegegeometrien problemlos realisieren.

Als beispiele zum Stand der Technik siehe US 2005/0120528 und US2005/0115039.

Nach dem Stand der Technik werden piezokeramische Mehrlagen-Bauteile bei etwa 1100 °C in Luft gesintert. Deshalb kann als Innenelektrode nur ein Edelmetall mit hoher Schmelztemperatur verwendet werden. Unedle Metalle würden oxidieren. Normalerweise wird deshalb eine Silber-Palladiumlegierung mit bis zu 40 % Palladium verwendet. Dies ist jedoch mit hohen Materialkosten verbunden.

Der Erfindung liegt die Aufgabe zugrunde, die Nachteile des Standes der Technik zu beheben.

Silber wird in der nachfolgenden Beschreibung nicht als Edelmetall eingestuft, obwohl es elektrochemisch betrachtet zu den Edelmetallen gehört.

Das erfindungsgemäße Bauteil enthält als Innenelektrode vorzugsweise reines Silber ohne sonstigen Edelmetallanteil. Da Silber bei 961 °C schmilzt und diese Temperatur in Gegenwart von piezokeramischen Material noch weiter absinkt, darf eine Sintertemperatur von 950 °C nicht überschritten werden. Erreicht wird dieses Ziel durch drei Maßnahmen:

1. Es muss eine bei niedrigen Temperaturen sinternde PZT- Keramik eingesetzt werden. Geeignet sind kodotierte PZT-Systeme wie sie z. B. in DE 19 840 488 A1 beschrieben werden. Der Werkstoff muss zudem möglichst fein gemahlen werden, um eine hohe Sinteraktivität zu erreichen.

2. Der PZT- Werkstoff muss gegenüber der Eindiffusion von Silber beim Sintern robust sein. Das aus der Innenelektrode eindiffundierende Silber senkt die Sintertemperatur weiter beträchtlich ab. Es darf aber die piezomechanischen Eigenschaften des Werkstoffs möglichst wenig beeinflussen. Auch hier eignen sich die beschriebenen kodotierten PZT-Systeme.

3. Die Innenelektrode muss durch Zusätze von PZT oder verwandten Keramikarten stabilisiert werden, da sie sonst weitgehend in die Keramik diffundiert, deren Eigenschaften verändert oder ihre Leitfähigkeit verliert.

Durch die erfindungsgemäße Kombination der drei Maßnahmen ist es möglich, die Sintertemperatur auf unter 900 °C abzusenken und ein Vielschicht-Biegeelement herzustellen, das als Schallwandler die gleichen Eigenschaften besitzt wie ein edelmetallhaltiger Biegewandler nach dem Stand der Technik.

Die Erfindung betrifft demnach ein Verfahren zur Herstellung eines Bauteils als monolithisches Vielschichtelement oder Vielschicht-Biegeelement, mit zumindest zwei Lagenpaketen mit jeweils 1 - 400 Lagen piezoelektrisch aktiven Materials, die durch mindestens ein Lagenpaket aus O-100 Lagen piezoelektrisch inaktiven Materials getrennt werden, wobei die Innenelektroden der aktiven Lagenpakete zumindest folgende Materialien enthalten:

a) reines Silber ohne sonstigen Edelmetallanteil
b) Blei: -Titanat-Zirkonat (PZT) als elektrisch nicht leitfähiges Material mit einem Gewichtsanteil von weniger als 15%

und das Material der piezoelektrisch aktiven Lagen eine derart ausreichende Aktivität in einem thermischen Prozess hat, dass ein Sintern unterhalb der Schmelztemperatur des Materials der Innenelektroden möglich ist und auch ausgeführt wird, und beim sintern eine Temperatur von 950°C nicht überschritten wird, und

das Silber der Innenelektroden im Ausgangszustand vor dem Sintern als kugelförmige Partikel (Pulver) vor.

Das Lagenpaket mit dem piezoelektrisch inaktiven Material kann also auch entfallen.

Die Lagenpakete des piezoelektrisch aktiven Materials werden vorteilhaft aus weniger als 100 Lagen, bevorzugt aus einer bis 10 Lagen zusammengesetzt.

Bevorzugt werden die Lagenpakete des piezoelektrisch inaktiven Materials aus einer bis 10 Lagen zusammengesetzt.

Für das elektrisch nicht leitfähige Material der Innenelektroden wird vorteilhaft ein Gewichtsanteil von weniger als 20 % bevorzugt weniger als 15 % verwendet.

In einer Ausgestaltung wird dem Material der Innenelektroden zusätzlich eine Metalllegierung oder eine Metalloxidmischung bestehend aus nicht mehr als 30 % Edelmetall mit Ausnahme von Silber zugegeben.

Der Anteil der zugegebenen Metalllegierung oder Metalloxidmischung kann einen Anteil von weniger als 10 %, bevorzugt weniger als 5 % oder auch 0 % aufweisen.

Mit %-Angaben sind in der gesamten Beschreibung immer Gewichtsprozente gemeint

In bevorzugter Ausgestaltung wird als Metalllegierung oder Metalloxidmischung Palladium oder Platin verwendet.

Als elektrisch nicht leitfähiges Material der Innenelektroden wird bevorzugt Blei-Titanat-Zirkonat (PZT), insbesondere aus einem kodotierten Material bestehend mit einem Anteil von 5% - 15% verwendet.

Beim Sintern darf eine Temperatur von 950 °C nicht überschritten werden, da Silber bei 961 °C schmilzt.

Die piezoelektrisch aktiven Lagenpakete werden zweckmäßigerweise mit je einer Schicht dielektrischen Materials abgedeckt, das beispielsweise als Dickschichtpaste aufgebracht wird.

Die Verbindung der Innenelektrodenschichten einer Polarität wird vorteilhaft mittels interner Verbindungen (Vias) hergestellt.

Bevorzugt werden die Vias vor dem Sintern angebracht.

In Ausgestaltung der Erfindung werden Folien- und Dickschichttechnik eingesetzt.

Die piezoelektrisch aktiven Lagen sind dünner als 200 $\mu$m und sind bevorzugt zwischen 15 und 100 $\mu$m dick.

Die piezoelektrisch aktiven Lagenpakete sind an der Unter- und Oberseite des Bauteils mit je einer passiven Deckschicht dielektrischen Materials abgedeckt.

Auf die passive Deckschicht sind bevorzugt am Fixierpunkt planare Kontaktbereiche, Dickschichtwiderstände oder Abgleichnetzwerke aufgebracht.

Das Bauteil kann eine beliebige flächige Form aufweisen, insbesondere ein Rechteck, eine runde oder ovale Scheibe, Sternform, Hantel- oder Löffelform sein.

Die Form des Bauteils ist bevorzugt so gewählt, dass bei einem gegebenen Fixierpunkt die Bereiche maximaler Schwingamplitude die maximale Masse aufweisen, so dass die auf den Fixierpunkt übertragene Kraft maximal ist.

Vorteilhaft sind bei gegebenem Fixierpunkt die Bereiche maximaler Schwingamplitude mit zusätzlichen Massen versehen, so dass die auf den Fixierpunkt übertragene Kraft maximal ist.

Bevorzugt ist die Beziehung

$$\int_0^L a(x,t) \cdot \rho(x) \cdot b(x) \cdot t(x) dx$$

durch die Bauteilform an sich zu einem gegebenen Zeitpunkt t maximiert,
wobei

a(x)     die Beschleunigung am Punkt x zur Zeit t,
b(x)     die Breite am Punkt x,
t(x)     die Dicke am Punkt x und
p (x)     die Dichte des Bauteils am Punkt x ist und x den Abstand vom Fixpunkt bezeichnet und L den maximalen Abstand von diesem Fixpunkt.

Bevorzugt wird das Bauteils zur Anregung oder Aufnahme von Schwingungen in beliebigen Strukturen verwendet, was dazu führt, dass die Schwingungen der Struktur in elektrische Signale umgewandelt werden oder die Struktur Schall abstrahlt.

Erfindungsgemäß kann das Bauteil als Mikrophon oder Lautsprecher verwendet werden.

Auch kann das Bauteil verwendet werden, um in beliebigen schwingenden Strukturen gegenphasige Schwingungen anzuregen, was dazu führt, dass in der Struktur die Schwingung ausgelöscht oder zumindest gedämpft wird.

Bevorzugt ist die Verwendung des Bauteils als Sensor für Schwingungen oder als Aktor zur Auslösung der Schwingungen.

Weitere Merkmale der Erfindung ergeben sich aus den Figuren, die nachfolgend beschrieben sind.

Figur 1 zeigt ein Vielschicht-Biegeelement, dessen aktive Lagenpakete 1 Elektroden aus edelmetallfreiem Material enthalten. Die aktiven Lagenpakete sind über die Außenmetallisierung 4 elektrisch kontaktiert. Das Bauteil ist mit Decklagen 3 aus PZT versehen, welche die elektrische Isolation sicherstellen und die Anschlussflächen 5 aufnehmen können.

Figur 2 zeigt zwei Möglichkeiten, die von einem Biegeelement erzeugten Schwingungen zu beeinflussen und die tieferen Frequenzen auf Kosten der höheren Frequenzen anzuheben. In (a) wird dies durch Anbringen von Zusatzmassen 6, in (f) durch eine löffelartige Ausformung 7 des Biegeelementes bewerkstelligt. Die Massen in (a) wirken dabei vorzugsweise durch ihre Trägheitskraft, die löffelförmigen Bereiche dagegen vorzugsweise durch ihren Luftwiderstand.

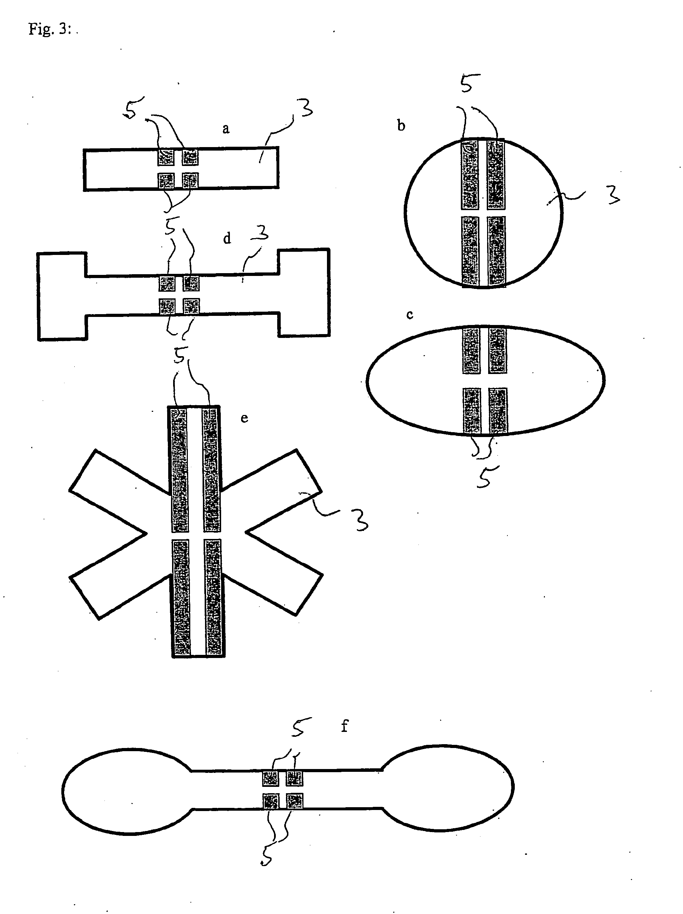

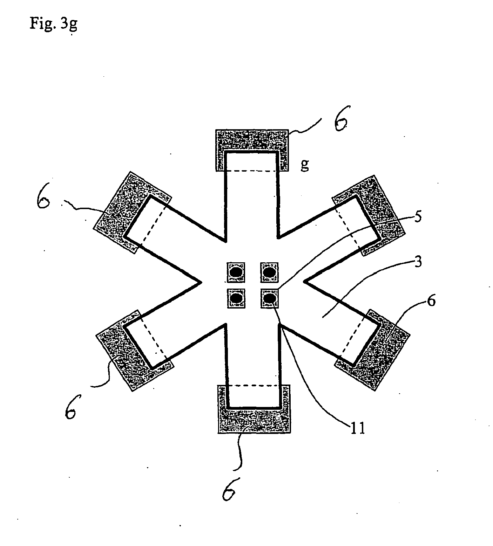

Figur 3 zeigt mögliche Bauformen der Biegeelemente. In (a) ist die rechteckige Standardform dargestellt. Die runden Formen (b) und (c) haben eine deutlich höhere Steifigkeit und können auch massive Strukturen zu Schwingungen anregen. Die Hantelform (d) und die Löffelform (f) sind eher für tiefere Frequenzen geeignet. Die Sternform (e) lässt sich in der Klangcharakteristik neutral abstimmen, indem man an jeden Bieger eine andere Abstimmasse 6 anbringt. Figur 3g zeigt ein sternförmiges Biegeelement mit einer Via-Durchkontaktierung 11 und Abstimmmassen 6.

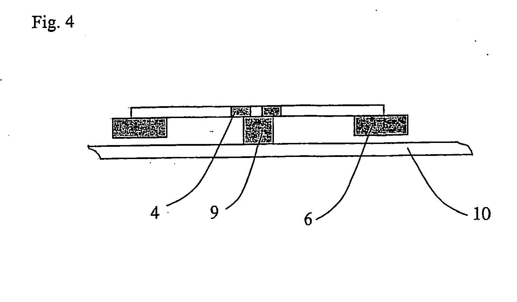

Figur 4 zeigt die mögliche Anbringung eines Biegeelementes mittels eines Koppelelements 9 an einer schwingenden Struktur 10. Die mechanischen Eigenschaften des Koppelelementes und der Klebung (Steifigkeit) beeinflussen vor allem die hohen Frequenzen.

Figur 5 zeigt die Audio-Spektren eines Biegeelements mit edelmetallhaltigen Innenelektroden nach dem Stand der Technik und einem Biegeelement mit Silber-Innenelektroden. (Beispiel 1 und Beispiel 2)

Figur 6 zeigt die Audio-Spektren von zwei Biegeelementen mit verschiedenen Silber-Innenelektroden, bei verschiedenen Temperaturen gesintert. (Beispiel 3 und Beispiel 4)

Figur 7 zeigt die Audio-Spektren von zwei Biegeelementen, mit und ohne Zusatzmassen. (Beispiel 6 und Beispiel 5)

Figur 8 zeigt die Audio-Spektren von zwei Biegeelementen, mit und ohne Hantelform. (Beispiel 7 und Beispiel 5)

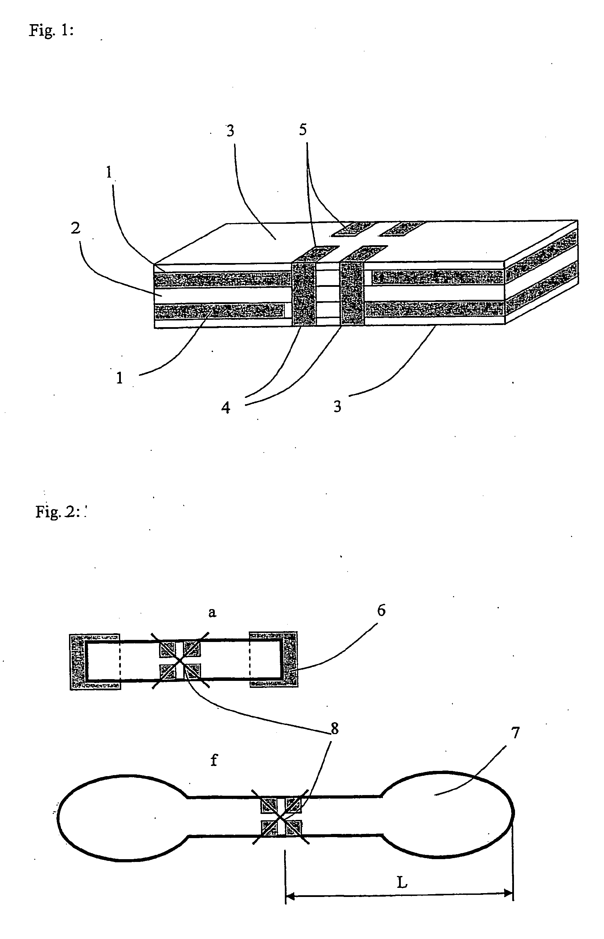

Herstellung eines Bauteils gemäß der Erfindung:
Zur der erfindungsgemäßen Herstellung Biegeelemente wird die Folientechnik verwendet. Die beschriebene Vorgehensweise und die beschriebenen Parameter geben nur ein Beispiel wieder. Dem Fachmann sind jederzeit ähnliche Vorgehensweisen und Parameter offensichtlich.
Ausgangspunkt ist ein kalziniertes PZT- Material nach DE 19840488, z. B. 0,98Pb($Zr_{0,53}Ti_{0,47}$)O$_3$-0,02Sr($K_{0,25}Nb_{0,75}$)O3. Das Material wird vorzerkleinert und in einer Ringspaltkugelmühle auf eine mittlere Korngröße von 0,8 μm gemahlen.
Aus dem entstandenen Pulver wird ein Gießschlicker nach dem Stand der Technik aufbereitet und zu einer Endlosfolie gegossen, getrocknet und aufgerollt. Hierfür eignen sich z. B. Gießbänder, die nach dem Doctor-Blade Verfahren arbeiten. Die Folie hat in diesem Beispiel nach dem Trocknen eine Dicke von 70 μm und nach dem Sintern eine Dicke von 60 μm.
Die Folie wird in Abschnitte von ca. 200 x 200 mm zerteilt. Das Innenelektrodenmuster wird mittels Siebdruck aufgedruckt. Durch die Form des Drucklayouts wird die spätere Abmessung des Biegeelementes definiert. Für das hier zu beschreibende Beispiel beträgt die spätere Abmessung 7 x 30 mm.
Die Innenelektrodenpaste wird aus einer Mischung von Silberpulver mit einem Anteil von 10 % des oben beschriebenen PZT- Pulvers hergestellt. Binder wie Ethylzellulose und Lösungsmittel wie Terpineol sorgen für die gute Verdruckbarkeit der Paste. Die Paste wird so aufgedruckt, dass die Dicke der Innenelektrode nach dem Sintern ca. 3 μm beträgt.
Die bedruckten und getrockneten Folienabschnitte werden so gestapelt, dass der Aufbau des Biegewandlers entsteht. Für das hier zu beschreibende Beispiel werden erst 4 bedruckte Folien, eine unbedruckte Folie, 4 bedruckte Folien und wiederum eine unbedruckte Folie übereinander gestapelt. Dadurch entsteht ein Biegeelement, das auf jeder Seite eine passive Lage 3, beidseitig je ein Paket 1 mit drei aktiven Lagen und zentral zwei passive Lagen 2 aufweist (Fig. 1).
Die gestapelten Folien werden nun nach Stand der Technik bei erhöhtem Druck und Temperatur zu einem Laminat zusammengepresst.
Das Laminat wird nun in die durch das Drucklayout vorgegebenen Biegeelemente durch z. B. Sägen oder Stanzen getrennt.
Die Biegeelemente werden bei einer Temperatur von 500 °C von den Binderanteilen befreit und anschließend bei 900 °C gesintert.
Die gesinterten Bauteile werden an den Schmalseiten geschliffen und mit einer Grundmetallisierung 4 aus einer handelsüblichen Silber-Dickschichtpaste bedruckt.
Auf die außen liegende Deckschicht werden mit der gleichen Paste Anschlussflächen 5 gedruckt. Die Metallisierung wird nach Herstellerangaben eingebrannt.
Durch Anlegen einer Spannung von 120 V werden die Bauteile nun so polarisiert, dass in den beiden Lagenpaketen 1 eine in einer Richtung durchgehende Polarisation entsteht.
Die Anschlussflächen werden nun so verbunden, dass das Biegeelement bipolar betrieben wird. Unter die Bauteilmitte wird ein Stützelement 10 geklebt, das die Verbindung zur schwingenden Struktur 9 herstellt. Das Stützelement soll klein, leicht und möglichst steif sein. Normalerweise erhält man gute Ergebnisse, wenn man das gleiche Material verwendet, aus dem die schwingende Struktur besteht. Es sind für den Fachmann aber auch andere Befestigungsmöglichkeiten naheliegend, die dem Verbund jeweils eine andere Schwingcharakteristik verleihen.

Beispiele:

Beispiel 1

Ein Vielschicht-Biegeelement mit den Abmessungen 7 x 30 x 0,6 mm wird nach dem oben beschriebenen Vorgehen hergestellt (Aufbau 4-1-4-1). Als Innenelektrodenmaterial wird eine handelsübliche Metallpaste mit AgPd 70/30 Legierung des Metallanteils verwendet. Die Bauteile werden bei 1000 °C gesintert.

Das Biegeelement wird in eine Standard-Kunststoffbox mit den Abmessungen 120 x 90 x 15 mm eingebaut und in einem Audio-Messplatz installiert. Der Abstand zum Messmikrophon beträgt dabei 10 cm, die Messspannung beträgt 10 Vss.

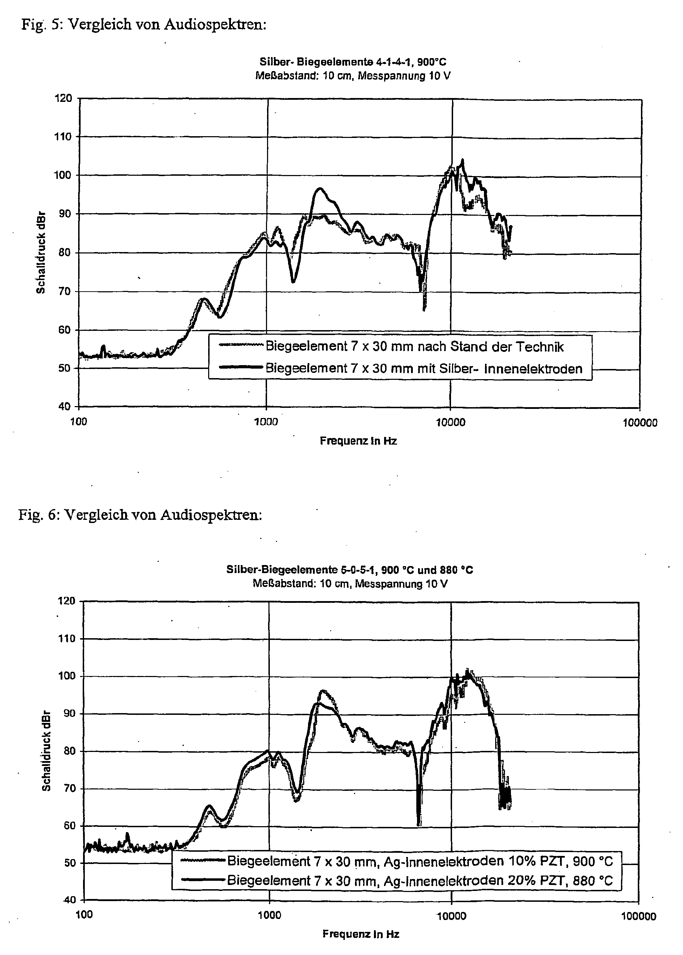

Es ergibt sich das in Fig. 5 dargestellte Schalldruckspektrum (graue Linie).

Beispiel 2

Ein Vielschicht-Biegeelement mit den Abmessungen 7 x 30 x 0,6 mm wird nach dem oben beschriebenen Vorgehen hergestellt (Aufbau 4-1-4-1). Als Innenelektrodenmaterial wird eine Mischung aus reinem Silberpulver (90 %) und fein gemahlenem PZT- Pulver (10 %) verwendet. Die Mischung wird mit Ethylcellulose und Terpineol zu einer Paste verrührt, die 50 % der Mischung enthält. Die Bauteile werden bei 900 °C gesintert.

Das Biegeelement wird in eine Standard-Kunststoffbox mit den Abmessungen 120 x 90 x 15 mm eingebaut und in einem Audio-Messplatz installiert. Der Abstand zum Messmikrophon beträgt dabei 10 cm, die Messspannung beträgt 10 Vss.

Es ergibt sich das in Fig. 5 dargestellte Schalldruckspektrum (schwarze Linie).

Es ist offensichtlich, dass das erfindungsgemäße Bauteil ein nahezu identisches Schalldruckspektrum erzeugt, wie ein Bauteil nach dem Stand der Technik.

Beispiel 3

Ein Vielschicht-Biegeelement mit den Abmessungen 7 x 30 x 0,66 mm wird nach dem oben beschriebenen Vorgehen hergestellt (Aufbau 5-0-5-1). Als Innenelektrodenmaterial wird eine Mischung aus reinem Silberpulver (90 %) und feingemahlenem PZT- Pulver (10 %) verwendet. Die Mischung wird mit Ethylcellulose und Terpineol zu einer Paste verrührt, die 50 % der Mischung enthält. Die Bauteile werden bei 900 °C gesintert.

Das Biegeelement wird in eine Standard-Kunststoffbox mit den Abmessungen 120 x 90 x 15 mm eingebaut und in einem Audio-Messplatz installiert. Der Abstand zum Messmikrophon beträgt dabei 10 cm, die Messspannung beträgt 10 Vss.

Es ergibt sich das in Fig. 6 dargestellte Schalldruckspektrum (graue Linie).

Beispiel 4 (nicht erfindungsgemäß)

Ein Vielschicht-Biegeelement mit den Abmessungen 7 x 30 x 0,66 mm wird nach dem oben beschriebenen Vorgehen hergestellt (Aufbau 5-0-5-1). Als Innenelektrodenmaterial wird eine Mischung aus reinem Silberpulver (80 %) und fein gemahlenem PZT- Pulver (20 %) verwendet. Die Mischung wird mit Ethylcellulose und Terpineol zu einer Paste verrührt, die 50 % der Mischung enthält. Die Bauteile werden bei 880 °C gesintert.

Das Biegeelement wird in eine Standard-Kunststoffbox mit den Abmessungen 120 x 90 x 15 mm eingebaut und in einem Audio-Messplatz installiert. Der Abstand zum Messmikrophon beträgt dabei 10 cm, die Messspannung beträgt 10 Vss.

Es ergibt sich das in Fig. 6 dargestellte Schalldruckspektrum (schwarze Linie). Der Vergleich mit dem Bauteil aus Beispiel 3 zeigt keine signifikanten Unterschiede.

Beispiel 5

Ein Vielschicht-Biegeelement mit den Abmessungen 7 x 30 x 0,78 mm wird nach dem oben beschriebenen Vorgehen hergestellt (Aufbau 6-0-6-1). Als Innenelektrodenmaterial wird eine Mischung aus reinem Silberpulver (90 %) und fein gemahlenem PZT- Pulver (10 %) verwendet. Die Mischung wird mit Ethylcellulose und Terpineol zu einer Paste verrührt, die 50 % der Mischung enthält. Die Bauteile werden bei 900 °C gesintert.

Das Biegeelement wird in eine Standard-Kunststoffbox mit den Abmessungen 120 x 90 x 15 mm eingebaut und in einem Audio-Messplatz installiert. Der Abstand zum Messmikrophon beträgt dabei 10 cm, die Messspannung beträgt 10 Vss (Volt Spitze/Spitze).

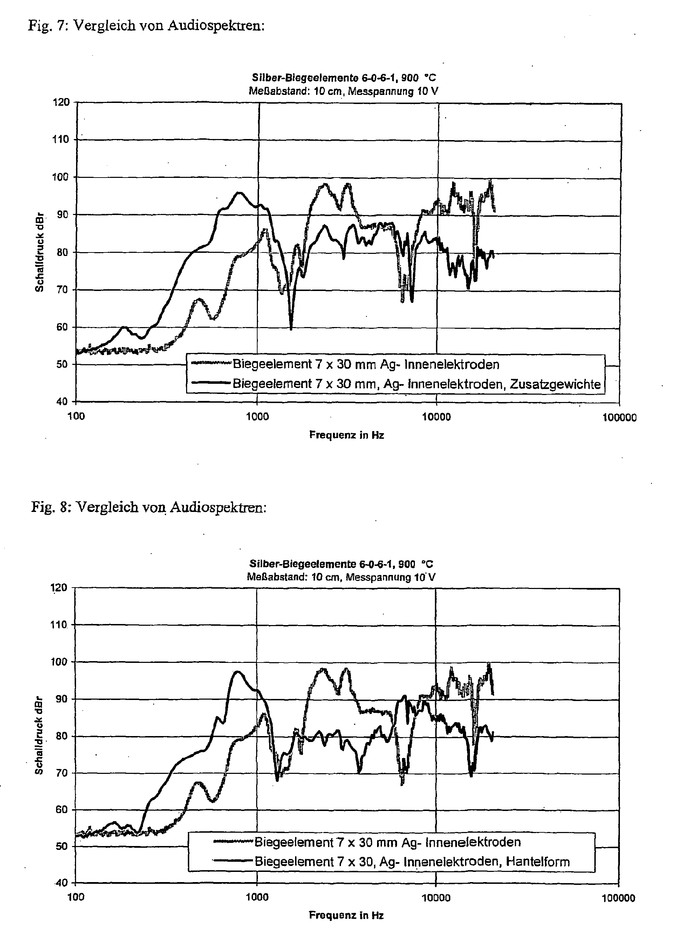

Es ergibt sich das in Fig. 7 dargestellte Schalldruckspektrum (graue Linie).

Beispiel 6

Ein Vielschicht-Biegeelement aus dem Beispiel 5 wird an den Enden mit zusätzlichen Metallgewichten von je 2,8 g versehen. Zum Fügen wird ein hoch elastischer Klebstoff (Silikon) verwendet.

Das Biegeelement wird in eine Standard-Kunststoffbox mit den Abmessungen 120 x 90 x 15 mm eingebaut und in einem Audio-Messplatz installiert. Der Abstand zum Messmikrophon beträgt dabei 10 cm, die Messspannung beträgt 10 Vss.

Es ergibt sich das in Fig. 7 dargestellte Schalldruckspektrum (schwarze Linie).

Der Vergleich der beiden Bauteile zeigt, dass durch die Zusatzgewichte die tiefen Frequenzen deutlich angehoben werden, wohingegen der Pegel der hohen Frequenzen abgesenkt wird.

Beispiel 7

Ein Vielschicht-Biegeelement aus dem Beispiel 5 wird an den Enden mit zusätzlichen 21 x 20 x 0,63 mm großen Flächen aus Aluminiumoxid- Substraten versehen. Die Überlappung mit dem Biegeelement beträgt 5 mm, so dass eine hantelartige Form entsteht. Zum Fügen wird ein hochelastischer Klebstoff (Silikon) verwendet.

Das Biegeelement wird in eine Standard-Kunststoffbox mit den Abmessungen 120 x 90 x 15 mm eingebaut und in einem Audio-Messplatz installiert. Der Abstand zum Messmikrophon beträgt dabei 10 cm, die Messspannung beträgt 10 Vss.

Es ergibt sich das in Fig. 8 dargestellte Schalldruckspektrum (schwarze Linie).

Der Vergleich mit dem Biegeelement ohne Hantelform (graue Linie) zeigt, dass durch die Hantelform die tiefen Frequenzen deutlich angehoben werden, wohingegen der Pegel der hohen Frequenzen abgesenkt wird.

**Patentansprüche**

1. Verfahren zur Herstellung eines Bauteils als monolithisches Vielschichtelement oder Vielschicht-Biegeelement, mit zumindest zwei Lagenpaketen (1) mit jeweils 1 - 400 Lagen piezoelektrisch aktiven Materials, die durch mindestens ein Lagenpaket (2) aus 0 - 100 Lagen piezoelektrisch inaktiven Materials getrennt werden, wobei die Innenelektroden der aktiven Lagenpakete folgende Materialien enthalten:

   a) reines Silber ohne sonstigen Edelmetallanteil
   b) Blei-Titanat-Zirkonat (PZT) als elektrisch nicht leitfähiges Material mit einem Gewichtsanteil <u>von weniger als 15 %</u>

   und das Material der piezoelektrisch aktiven Lagen eine derart ausreichende Aktivität in einem thermischen Prozess hat, dass ein Sintern unterhalb der Schmelztemperatur des Materials der Innenelektroden möglich ist und auch ausgeführt wird und beim Sintern eine Temperatur von 950 °C nicht überschritten wird. und das Silber der Innenelektroden im Ausgangszustand vor dem Sintern als kugelförmige Partikel (Pulver) vorliegt.

2. Verfahren nach Anspruch 1, **dadurch gekennzeichnet, dass** die Lagenpakete des piezoelektrisch aktiven Materials aus weniger als 100 Lagen, bevorzugt aus einer bis 10 Lagen zusammengesetzt werden.

3. Verfahren nach Anspruch 1 oder 2, **dadurch gekennzeichnet, dass** die Lagenpakete des piezoelektrisch inaktiven Materials aus einer bis 10 Lagen zusammengesetzt werden.

4. Verfahren nach einem der Ansprüche 1 bis 3, **dadurch gekennzeichnet, dass** als elektrisch nicht leitfähiges Material der Innenelektroden kodotiertes Blei-Titanat-Zirkonat (PZT) verwendet wird.

5. Verfahren nach einem der Ansprüche 1 bis 4, **dadurch gekennzeichnet, dass** die piezoelektrisch aktiven Lagenpakete mit je einer Schicht dielektrischen Materials (3) abgedeckt werden, das beispielsweise als Dickschichtpaste aufgebracht wird.

6. Verfahren nach einem der Ansprüche 1 bis 5, **dadurch gekennzeichnet, dass** die Verbindung der Innenelektrodenschichten einer Polarität mittels interner Verbindungen (Vias) hergestellt wird.

7. Verfahren nach Anspruch 6, **dadurch gekennzeichnet, dass** die Vias vor dem Sintern angebracht werden.

8. Verfahren nach einem der vorhergehenden Ansprüche, **dadurch gekennzeichnet, dass** Folien- und Dickschichttechnik eingesetzt werden.

9. Verwendung eines Bauteils hergestellt mit dem Verfahren nach einem der Ansprüche 1 bis 8 zur Anregung oder Aufnahme von Schwingungen in beliebigen Strukturen, was dazu führt, dass die Schwingungen der Struktur in elektrische Signale umgewandelt werden oder die Struktur Schall abstrahlt.

10. Verwendung des Bauteils nach Anspruch 9 als Mikrophon oder Lautsprecher.

11. Verwendung des Bauteils nach Anspruch 9 oder 10 um in beliebigen schwingenden Strukturen gegenphasige Schwingungen anzuregen, was dazu führt, dass in der Struktur die Schwingung ausgelöscht wird.

12. Verwendung des Bauteils nach einem der Ansprüche 9 bis 11 als Sensor für Schwingungen oder als Aktor zur Auslösung der Schwingungen.

**Claims**

1. A process for producing a structural component in the form of a monolithic multilayer element or multilayer flexural element, with at least two layer stacks (1) with, in each case, 1-400 layers of piezoelectrically active material, which are separated by at least one layer stack (2) consisting of 0-100 layers of piezoelectrically inactive material, wherein the internal electrodes of the active layer stacks contain the following materials:

   a) pure silver without other precious-metal content

b) lead zirconate titanate (PZT) as electrically non-conductive material with a proportion by weight of less than 15 %

and the material of the piezoelectrically active layers has sufficient activity in a thermal process such that sintering is possible below the melting-temperature of the material of the internal electrodes, and is also performed, and a temperature of 950 °C is not exceeded in the course of sintering, and in the initial state prior to sintering the silver of the internal electrodes is present in the form of spherical particles (powder).

2. A process according to claim 1, **characterised in that** the layer stacks of the piezoelectrically active material are composed of fewer than 100 layers, preferably of one to 10 layers.

3. A process according to claim 1 or 2, **characterised in that** the layer stacks of the piezoelectrically inactive material are composed of one to 10 layers.

4. A process according to one of claims 1 to 3, **characterised in that** co-doped lead zirconate titanate (PZT) is used as electrically non-conductive material of the internal electrodes.

5. A process according to one of claims 1 to 4, **characterised in that** the piezoelectrically active layer stacks are each covered with a film of dielectric material (3) which is applied, for example, in the form of thick-film paste.

6. A process according to one of claims 1 to 5, **characterised in that** the connection of the internal-electrode films of one polarity is established by means of internal connections (vias).

7. A process according to claim 6, **characterised in that** the vias are attached prior to sintering.

8. A process according to one of the preceding claims, **characterised in that** foil technology and thick-film technology are employed.

9. Use of a structural component produced by the process according to one of claims 1 to 8 for the purpose of exciting or accepting oscillations in arbitrary structures, which has the result that the oscillations of the structure are converted into electrical signals or the structure radiates sound.

10. Use of the structural component according to claim 9 as a microphone or loudspeaker.

11. Use of the structural component according to claim 9 or 10 in order to excite antiphase oscillations in arbitrary oscillating structures, which has the result that the oscillation in the structure is extinguished.

12. Use of the structural component according to one of claims 9 to 11 as a sensor for oscillations or as an actuator for triggering oscillations.

## Revendications

1. Procédé de fabrication d'un élément en tant qu'élément multicouche ou élément fléchissant multicouche monolithique, comprenant au moins deux empilements de couches (1) avec respectivement 1 à 400 couches de matériau à activité piézoélectrique, qui sont séparées par au moins un empilement de couches (2) formé de 0 à 100 couches de matériau sans activité piézoélectrique, les électrodes internes des empilements de couches actifs contenant les matériaux suivants :

a) argent pur, sans autres fractions de métaux précieux;
b) zirconate titanate de plomb (PZT) en tant que matériau non conducteur électrique, avec un rapport de poids <u>inférieur à 15 %,</u>

et le matériau des couches à activité piézoélectrique présentant une activité dans un processus thermique qui est telle qu'un frittage est possible à une température inférieure à la température de fusion du matériau des électrodes internes, et est effectivement réalisé, et une température de 950 °C n'étant pas dépassée lors du frittage, et l'argent des électrodes internes étant présent, à l'état initial avant le frittage, sous forme de particules sphériques (poudre).

2. Procédé selon la revendication 1, **caractérisé en ce que** les empilements de couches du matériau à activité piézoélectrique sont assemblés à partir de moins de 100 couches, de préférence à partir d'une à 10 couches.

3. Procédé selon la revendication 1 ou 2, **caractérisé en ce que** les empilements de couches du matériau sans activité piézoélectrique sont assemblés à partir d'une à 10 couches.

4. Procédé selon une des revendications 1 à 3, **caractérisé en ce que** l'on utilise du zirconate titanate de plomb (PZT) codopé en tant que matériau non conducteur électrique des électrodes internes.

5. Procédé selon une des revendications 1 à 4, **caractérisé en ce que** les empilements de couches à activité piézoélectrique sont recouverts respectivement avec une couche de matériau diélectrique (3) qui est appliqué par exemple en tant que pâte à couche épaisse.

6. Procédé selon une des revendications 1 à 5, **caractérisé en ce que** la connexion entre les couches d'une même polarité des électrodes internes est établie à l'aide de liaisons internes (vias).

7. Procédé selon la revendication 6, **caractérisé en ce que** les vias sont réalisés avant le frittage.

8. Procédé selon une des revendications précédentes, **caractérisé en ce que** l'on utilise des techniques de films et de couches épaisses.

9. Utilisation d'un élément fabriqué par le procédé selon une des revendications 1 à 8, à des fins de génération ou d'absorption d'oscillations dans tous types de structures, ce qui a pour conséquence que les oscillations de la structure sont converties en signaux électriques ou que la structure émet des sons.

10. Utilisation de l'élément selon la revendication 9, en tant que microphone ou haut-parleur.

11. Utilisation de l'élément selon la revendication 9 ou 10, afin de générer des oscillations en opposition de phase dans tous types de structures oscillantes, ce qui a pour effet d'arrêter l'oscillation dans la structure.

12. Utilisation de l'élément selon une des revendications 9 à 11, en tant que capteur d'oscillations ou en tant qu'actionneur pour déclencher les oscillations.

Fig. 1:

Fig. 2:

L

Fig. 3:

Fig. 3g

Fig. 4

4   9   6   10

Fig. 5: Vergleich von Audiospektren:

**Silber- Biegeelemente 4-1-4-1, 900°C**
Meßabstand: 10 cm, Messpannung 10 V

Biegeelement 7 x 30 mm nach Stand der Technik
Biegeelement 7 x 30 mm mit Silber- Innenelektroden

Frequenz in Hz

Fig. 6: Vergleich von Audiospektren:

**Silber-Biegeelemente 5-0-5-1, 900 °C und 880 °C**
Meßabstand: 10 cm, Messpannung 10 V

Biegeelement 7 x 30 mm, Ag-Innenelektroden 10% PZT, 900 °C
Biegeelement 7 x 30 mm, Ag-Innenelektroden 20% PZT, 880 °C

Frequenz in Hz

13

Fig. 7: Vergleich von Audiospektren:

**Silber-Biegeelemente 6-0-6-1, 900 °C**
**Meßabstand: 10 cm, Messpannung 10 V**

Biegeelement 7 x 30 mm Ag- Innenelektroden
Biegeelement 7 x 30 mm, Ag- Innenelektroden, Zusatzgewichte

Frequenz in Hz

Fig. 8: Vergleich von Audiospektren:

**Silber-Biegeelemente 6-0-6-1, 900 °C**
**Meßabstand: 10 cm, Messpannung 10 V**

Biegeelement 7 x 30 mm Ag- Innenelektroden
Biegeelement 7 x 30, Ag- Innenelektroden, Hantelform

Frequenz in Hz

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20050120528 A
- US 20050115039 A

- DE 19840488 A1
- DE 19840488